# EUROPEAN PATENT SPECIFICATION

(11) **EP 0 414 835 B1**
(45) Date of publication and mention of the grant of the patent: **19.10.1994**
(21) Application number: 90901640.4
(22) Date of filing: 12.01.1990
(51) Int. Cl.: H05K 7/14

(54) **CONNECTOR ELEMENT**
VERBINDUNGSELEMENT
ELEMENT DE CONNEXION

(30) Priority: 12.01.1989 GB 8900663
(43) Date of publication of application: 06.03.1991
(73) Proprietor: BARRY CONTROLS LIMITED, Walton-on-Thames Surrey KT12 3PQ (GB)
(72) Inventor: ROOKE, Michael, Paul, Middlesex TW16 5BB (GB)
(74) Representative: Abrams, Michael John
(86) International application number: GB9000043
(87) International publication number: WO9008453

(56) References cited:
- EP-A- 0 105 609
- EP-A- 0 304 237
- GB-A- 2 206 748

## Description

This invention relates to a connector element. The connector element described herein has particular application for connecting two components in a system which is likely to be subject to vibration. Such a connector element is disclosed in GB-A-2 206 748.

Our European Patent Application No. 88307475.9 (Publication No. 0304237, published 22/2/89) describes and claims a connector element for use in connecting together two components, the components having respective surfaces, which, when the components are connected together, abut one another, the connector element comprising:
i) a shaft having a threaded end region and, remote from said end region, a radial flange, the shaft further having a passageway extending axially for at least part of its axial length;
ii) a sleeve coaxial with and positioned around the shaft, the sleeve having an end surface proximate the threaded end region of the shaft and a radial flange remote from said end surface;
iii) biasing means arranged between the radial flange of the shaft and the radial flange of the sleeve to urge the sleeve axially along the shaft in a direction away from the radial flange on the shaft;
iv) an elongate member disposed for movement along the passageway in the shaft and coupled to the sleeve so as to undergo such movement in dependence upon axial movement of the sleeve, the elongate member having a region extending out of the shaft at the end thereof remote from the threaded end region of the shaft; and
v) indicating means coupled to said region of the elongate member and responsive to movement thereof to indicate whether the shaft and the sleeve are in predetermined relative positions.

In one application such predetermined relative positions can be indicative that two components just abut.

The connector element can include a rotatable grip remote from said threaded end region of the shaft and coupled to the shaft so that rotation of said grip causes rotation of said shaft, said end region of the elongate member extending axially of the grip.

In one embodiment, disclosed in EPA 88307475.9 the grip includes means providing a surface having a slot, and the indication means comprises a further elongate member (indicator lever) pivotally mounted to said end region of the first-mentioned elongate member. The arrangement is such that the connector element operates as follows:
when the connector element is not in use the sleeve is urged by the biasing means in the direction away from the radial flange on the shaft, thereby causing the elongate member to adopt a first position in which part of the indicating element protrudes above the surface of the grip to indicate that the components are not correctly relatively positioned. In the first embodiment, the resilient planar indicating element sits in the recessed portion of the grip, whereby the shape of the indicator element is deformed so that its edges protrude above the grip surface. In the second embodiment, the indicator lever is pivoted so that its end protrudes from the slot. When the connector element is in use to connect together two such components, the indicating element will remain in that first position until the predetermined relative positions of the sleeve and shaft have been reached, when the sleeve causes the indicating element to move against the action of the biasing means towards the radial flange of the shaft thereby urging the elongate member towards the second position in which the indicating element lies flush against the grip surface, thereby indicating that the components are correctly relatively positioned. In the first embodiment the resilient planar indicating element is released from the recessed portion so that it lies flush against the grip surface. In the second embodiment the indicator lever lies within the slot.

We have now devised a modification of the connector system described above. This modification is of particular use in that the indicator element is activated, i.e. gives its indication, only when two conditions are satisfied: firstly, that the shaft and sleeve of the connector element are in predetermined relative positions (as in the case of EPA 88307475.9); and secondly, that there is a predetermined force urging the components (which are to be secured together through the connector element) towards one another. The predetermined force may, for example, be or may correspond to the minimum force desired to achieve proper mating connection between the two components.

According to one aspect of the present invention, there is provided a connector element for use in connecting together two components, the components having respective surfaces, which, when the components are connected together, abut one another, the connector element comprising:
i) a shaft having a threaded end region and, remote from said end region, a radial flange, the shaft further having a passageway extending axially for at least part of its axial length;
ii) a sleeve coaxial with and positioned around the shaft, the sleeve having an end surface proximate the threaded end region of the shaft and a radial flange remote from said end surface;
iii) biasing means arranged between the radial flange of the shaft and the radial flange of the sleeve to urge the sleeve axially along the shaft in a direction away from the radial flange on the shaft;
iv) an elongate member disposed for movement along the passageway in the shaft and coupled to the sleeve so as to undergo such movement in dependence upon axial movement of the sleeve, the elongate member having a region extending out of the shaft at the end thereof remote from the threaded end region of the shaft; and
v) indicating means coupled to said region of the elongate member and responsive to movement thereof; and
vi) further biasing means tending to urge said indicating means away from said shaft whereby said indicating means indicate when the force urging said two components into abutment exceeds a predetermined value.

The connector element preferably includes a rotatable grip remote from said threaded end region of the shaft and coupled to the shaft so that rotation of said grip causes rotation of said shaft, said end region of the elongate member extending axially of the grip.

Advantageously, the indicating means is arranged to respond to a force which is directly proportional to the force urging the two components into abutment; this can be achieved, for example, by inclusion of the further biasing means tending to urge said indicating means away from said shaft.

The further biasing means acts so that proximity of the two components which are to be connected together is not of itself sufficient to cause the indicator means to change its indication; the force tending to bring the two components into abutment, which force is exerted through action of the connector element, must be sufficient to overcome the resistance of the further biasing means before a change of indication is given by the indicator element.

Preferably the shaft is formed with a slot in which slides a bar which is secured to the sleeve to extend diametrically thereof and which is fixedly secured to the first-mentioned elongate member.

In the preferred embodiment the grip incorporates a torque limiting device for limiting the torque applied to the shaft after two components have been correctly relatively positioned, as indicated by the indicating means.

Since the connector element of the preferred embodiment of the present invention incorporates a torque limiting device, itwill be referred to hereinafter as torque limited bolt.

The connector element described hereinafter can ensure that two components are held together in abutment with the desired force when the connector element is done up: also, it is resistant to vibration so that it wi not inadvertently come undone while in use. Preferably, the connector element should be able to be positively locked against undoing itself under the influence of vibration. In addition, the connector element should preferably not exert a force greater than is required just to ensure that the components abut.

For a better understanding of the present invention and to show how the same may be carried into effect, reference will now be made, by way of example, to the accompanying drawings, in which:-
Figure 1 is an axial section through one embodiment of a bolt ready for use;
Figure 2 is a view from the end of Figure 1;
Figure 3 is an axial section of the bolt of Figure 1 in use;
Figure 4 is an end view of the bolt of Figure 3;
Figure 5 is a side elevation of the bolt; and
Figure 6 is a diagrammatic side view corresponding to Fig. 5 but with a part removed to illustrate the cooperation of ratchet teeth.

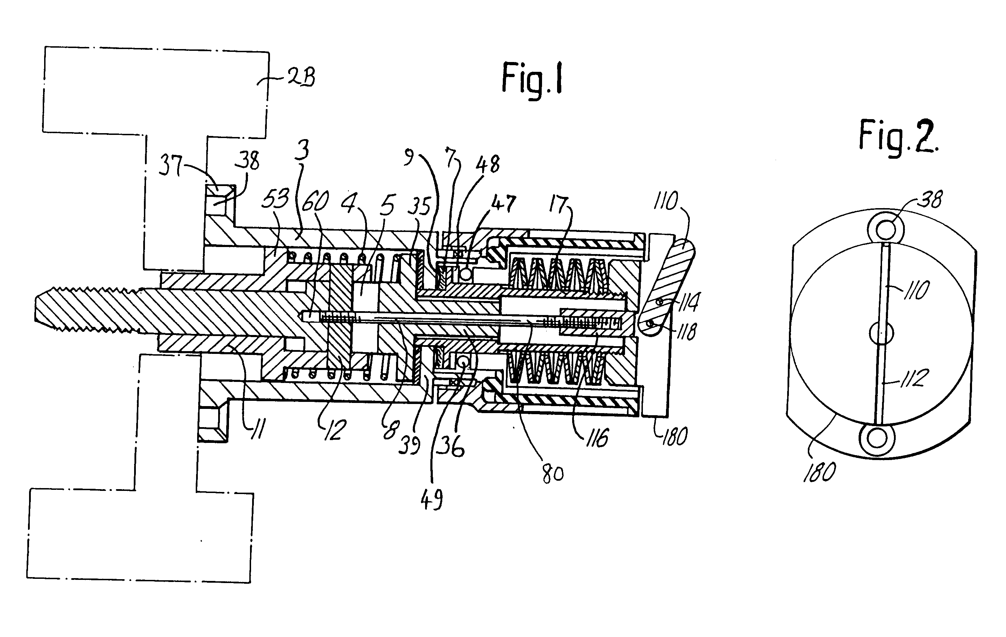

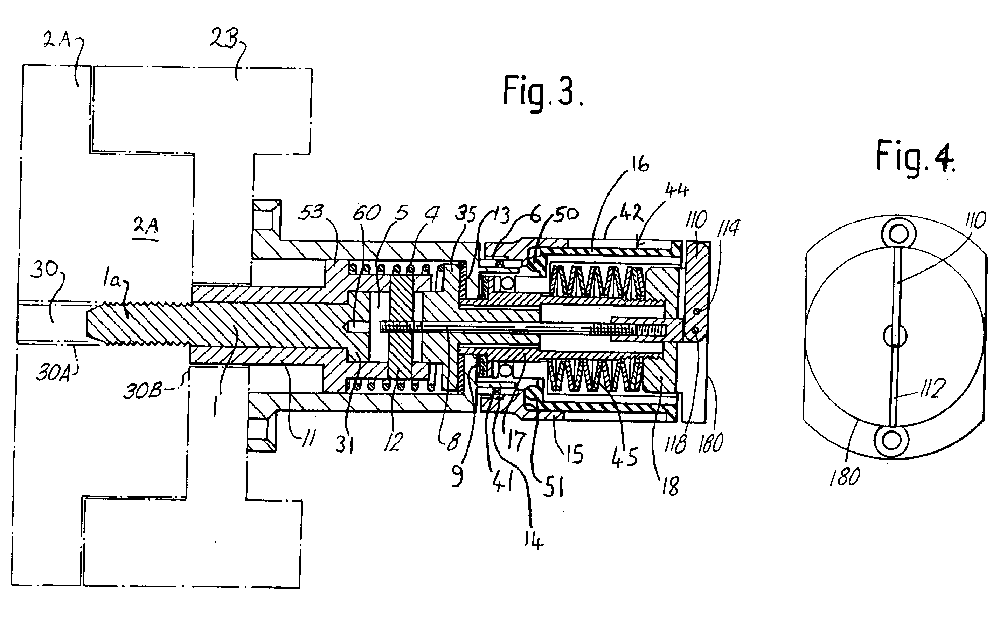

Reference is made to Figures 1 to 4. It is noted that not all of the reference numerals present in Figures 1 and 2 are duplicated in Figures 3 and 4, and vice versa. This is for reasons of clarity.

The purpose of the bolt is to ensure that two mating components 2A and 2B are fixedly relatively secured in a vibration proof manner. For this purpose, the bolt is permanently in place relative to the mating component 2B shown in Figure 1 and 2, and when component 2A is brought into contact with the component 2B the bolt is done up until the components just mate, whereafter a predetermined torque is applied to maintain a secure connection.

The bolt comprises a shaft 1 screw threaded at one end 1a to engage a correspondingly screw threaded hole 30 in one 2A of the two mating components 2A, 2B. The shaft 1 is formed with a portion 31 of larger diameter than that of the end 1 a, this portion 31 of larger diameter having a slot 5 formed therein. The shaft 1 also has a radial flange 35 and on one side of this flange 35 (to the right in Figure 1) a smaller diameter portion 36 extending within a sleeve 17. The smaller diameter portion 36 is fixedly secured to the sleeve 17 to rotate therewith. It is possible however to replace one shaft by another to accommodate different sized shafts. The shaft 1 has a passageway 60 formed therein for receiving a rod 8 of an indicating mechanism to be described in more detai I hereinafter. A portion 80 of the member 8 extends out of the shaft 1 (at the right hand end thereof as seen in the drawings). A thrust washer 7 is keyed onto the sleeve 17.

A cylindrical casing 3 has a flange 37 to be secured to the component 2B by means of holes 38 in combination with screws or other suitable securing elements. As an alternative, the casing 3 can be formed as part of the component 2B. In any event, the casing 3 enables the bolt to be left permanently in place relative to component 2B, the shaft 1 passing through a hole 30B in the component 2B aligned with the threaded hole 30A. The casing 3 has a front wall 39 provided with an aperture for receiving the sleeve 17. A thrust washer 13 for extraction is provided between the flange 35 of the shaft and the front wall 39 of the casing 3. One or more disc springs 9 are located between thrust washer 7 and a flange 39 of casing 3. These disc springs 9 act as biasing means which play an important part in controlling the action of an indicating element 110, as will be described hereinafter in greater detail.

The casing 3 also carries an axially extending cylindrical portion 41, having serrated teeth 6 the purpose of which is described in more detail hereinafter. A rotatable grip 42 is fitted about the sleeve 17, the grip 42 comprising an external collar 15 and a knob 44. The knob 44 carries a colour coded elastomeric cylinder 16. The colour coding is indicative of the maximum torque which can be applied by the bolt. The collar 15 can slide but not rotate relative to the knob 44. The elastomeric cylinder 16 has fourcircumferen- tially spaced protrusions 50 which provide a biasing force against a recessed surface 51 of the collar 15. The collar 15 is castellated so as to co-operate with respective ridges in the collar 15 to provide resistance to turning the knob 16. This assists in preventing vibrational effects from undoing the bolt once secured.

The knob 44 has, at its right hand end as seen in Figure 1, a recess in which are disposed a pack of disc springs (for example Belleville washers) 45. The springs are held in position by an adjustable nut 18 having an end portion 180.

The axially extending portion 41 of the casing 3 forms an annular recess which co-operates with the collar 15 of rotatable grip 42 and the sleeve 17 to define an annular cavity housing a torque limiting arrangement 47. The torque limiting arrangement is as described in European Patent Application No. 83305061.0 (Publication No. 0105609) and comprises a drive plate 48 and a plurality of ball bearings 49. Operation of the arrangement is described in detail in EPA0105609 and will hence not be described in more detail hereinafter.

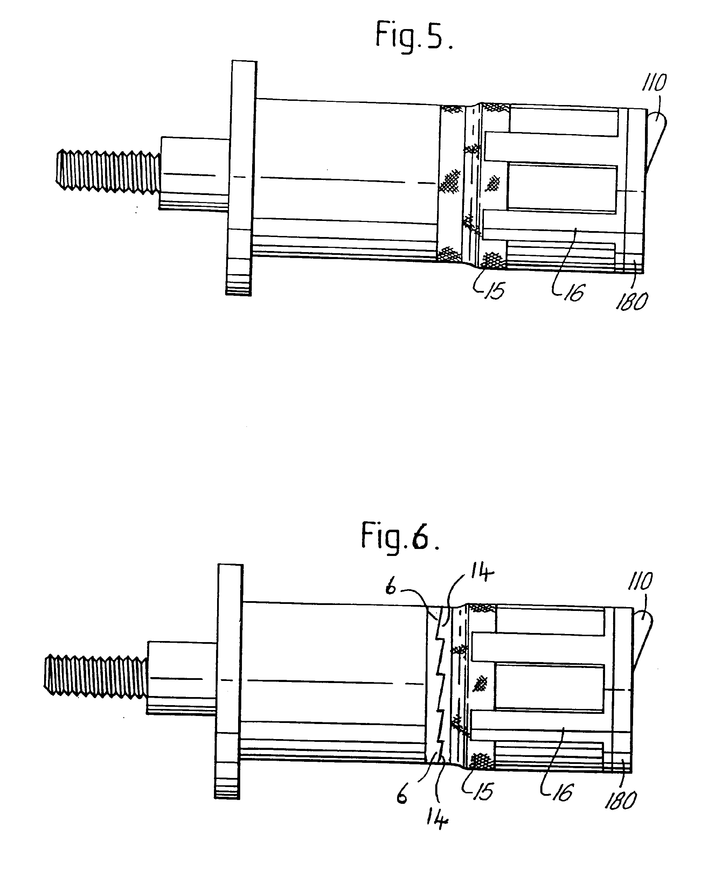

The collar 15 is removably secured to the axially extending portion 41 of the casing 3 via a positive self locking rachet mechanism. The rachet mechanism comprises the set of "saw teeth" 6 on the axially extending portion 41 co-operating with a set of similar teeth 14 on the collar 15. The saw teeth are so shaped (see Figure 6) that the leading edge has a smaller gradient than the trailing edge whereby rotation of the collar 15 of the grip 42 in one direction is permitted (the direction which cause the bolt to be tightened), against resistance caused by the action of the trailing surface of a tooth on the collar 15 sliding "up and over" the leading surface of a tooth on the axially extending portion 41. Rotation in the opposite direction is prevented unless the collar 15 is pulled axially away, against the action of the protrusion 50 of the elastomeric cylinder 16, from the axially extending portion 41 to release the teeth. Once done up, there is hence no danger of the bolt coming undone.

The indicating mechanism will now be described in detail. The mechanism includes a sleeve or collar 11 encircling the shaft 1 between the latter and the hole 30B and a T-piece 12 located in apertures in the collar 11 and assembled onto one end of the rod 8 so as to be slidable (with axial movement of the rod 8) along the slot 5. The T-piece 12 is secured to the rod 8 by screwing. In this way, the operable length of the rod 8 can be adjusted as described later. The collar 11 has a flange 53; between this flange and the flange 35 of the shaft 1 is arranged a coi spring 4. At the end of the rod 8 remote from said one end is a push rod 116 which is screw threadedly secured to the rod 8. While it might be simplest to manufacture the push rod 8 with a screw thread along its entire length, a screw thread is only required at the one end where it is connected to the T-piece 12 and at the other end where it is connected to the push rod 116.

The adjustable nut 18 has a slot 112 formed in its end portion 180. An indicator lever 110 is located within the slot 112 by a pivot pin 114. The end of push rod 116 is attached to the indicator lever 110 by means of a further pivot pin 118. The proximity of pivot points 114 and 118 serves to amplify the movement of lever 110 in response to movement of push rod 116. The width of the indicator lever is less than the diameter ofthe push rod 116 in order that the indicator lever can be held axially with the push rod and both items screwed onto the rod 8. In this way, the bolt can be set up by positioning the collar 11 flush with the face of the connector 2b and screwing the push rod complete with the indicator lever assembled on the pivot pin 118 until the indicator lever can be positioned at 90° relative to the push rod 116, so that it lies flush within the slot adjusting nut 180 as shown in Figure 3.

Operation of the bolt is as follows. In the unmated condition of the components 2A, 2B, the spring 4 maintains the collar 11 in a position such that it protrudes through one of the mating connectors 2B.

The coil spring 4 pulls the end of the indicator lever 110 secured to the push rod 116 thereby causing the end of lever 110 remote from pivot point 118 to protrude from the slot 112 in the adjusting nut 180 to indicate thereby the unmated condition of the connector.

When the thread of the shaft 1 is engaged in the connector 2A, the knob 44 is rotated to draw the two connectors 2A, 2B together. As the knob 44 rotates it turns the collar 15, the serrated teeth 6 of which are allowed to ride over the serrated teeth 14 of the casing 3 against the pressure exerted by the circumferentially spaced protrusions of the elastomeric cylinder 16. Disc springs 9, located between thrust washer 7 and flange 39, bias the sleeve 17, the shaft 1 and the collar 11 away from the component 2B to which casing 3 is secured. When components 2Aand 2B come into abutment as a result of continued rotation of knob 44, there is a tensile force which tends to compress the disc springs 9 and which pulls sleeve 17, shaft 1 and collar 11 towards component 2A relative to casing 3. At a predetermined force, the collar 11 is pushed back relative to shaft 1, which causes the T-piece 12 and hence the rod 8 and push rod 116 to be moved axially. This in turn causes indicator element 110 to pivot counterclockwise about pivot point 114 (as seen in the drawings), and thereby to come into the slot 112 in the part 180. Thus only when there is a predetermined force urging components 2A and 2B into abutment will the indicator element change from its extended condition (indicative of the unmated condition of components 2Aand 2B) to its recessed condition (indicative not just of the proximity of components 2A and 2B, but of the proper force required to maintain the two components in their mated condition).

The knob 44 is further rotated until the torque limit is reached [as described in European patent publication 0105609, to which reference is made above] after which the torque limiting mechanism 47 will slip and the shaft 1 will no longer be driven.

Any anti-clockwise rotation of the knob 44 under vibration is prevented by the collar 15 and the cooperation of its serrated teeth 14 with the serrated teeth 6 under the reaction of the elastomeric protrusions 50. In order to undo the bolt and to separate the connectors 2A, 2B, the collar 15 must be pulled back against the force of the elastomeric cylinder 16 on the knob 44 to disengage the rachet of the serrated teeth and the whole knob rotated anti-clockwise. This must be repeated until the connectors are disengaged. However, as soon as the connectors part, the action of spring 4 causes the indicator lever 110 to be pivoted clockwise (as seen in the drawings) about pivot point 114, thereby causing the end of the lever to protrude from slot 112 once more.

A most important feature of the bolt is that the indicating mechanism provides an easily visible effect to show whether or not the components are mated and held together with the correct force. This can be seen most readily from Figure 1, in which the lever 110 protrudes from slot 112 to indicate the unmated condition. When the connectors are correctly mated, the lever 110 lies flush within slot 112 in the surface of part 180.

Another particular feature of the described bolt is that the thrust washer 7 keyed onto the sleeve 17 causes the components of the bolt to the left of the wall 39 to be maintained in tension relative to end wall 39. Vibrational effects on the bolt to the left of end wall 39 are hence reduced.

It will be appreciated that the strength of disc washers 9 is selected in accordance with the desired mating force intended for the components 2Aand 2B.

## Claims

1. Aconnectorelementforuse in connecting together two components (2A, 2B), the components having respective surfaces, which, when the components are connected together, abut one another, the connector element comprising:
i) a shaft (1) having a threaded end region (la) and, remote from said end region, a radial flange (35), the shaft further having a passageway (60) extending axially for at least part of its axial length;
ii) a sleeve (11) coaxial with and positioned around the shaft (1), the sleeve (11) having an end surface proximate the threaded end region of the shaft and a radial flange (53) remote from said end surface;
iii) biasing means (4) arranged between the radial flange (35) of the shaft (1) and the radial flange (53) of the sleeve (11) to urge the sleeve axially along the shaft in a direction away from the radial flange on the shaft;
iv) an elongate member (8) disposed for movement along the passageway (60) in the shaft (1) and coupled to the sleeve (11) so as to undergo such movement in dependence upon axial movement of the sleeve, the elongate member having a region (80) extending out of the shaft at the end thereof remote from the threaded end region (la) of the shaft;
v) indicating means (110) coupled to said region (80) of the elongate member (8) and responsive to movement thereof; and
vi) further biasing means (9) tending to urge said indicating means (110) away from said shaft (1) whereby said indicating means (110) indicate when the force urging said two components (2A, 2B) into abutment exceeds a predetermined value.

2. A connector element as claimed in claim 1, which further comprises a rotatable grip (42) remote from said threaded end region (la) of the shaft and coupled to the shaft (1) so that rotation of said grip causes rotation of said shaft, said end region (80) of the elongate member extending axially of the grip (42).

3. A connector element as claimed in claim 2, wherein said grip (42) incorporates a torque limiting device (47, 48, 49) for limiting the torque applied to the shaft (1) after said two components have been correctly relatively positioned, as indicated by the indicating means (110).

4. A connector element as claimed in claim 1, 2 or 3, wherein said indicating means (110) is arranged to respond to a force which is directly proportional to the force urging the two components (2A, 2B) into abutment.

5. A connector element as claimed in any preceding claim, wherein said indicating means (110) is responsive to movement of the elongate member (8) to indicate whether the shaft (1) and the sleeve (11) are in predetermined relative positions.

6. A connector element as claimed in any preceding claim, wherein said shaft (1) is formed with a slot (5) in which slides a bar (12) which is secured to the sleeve (11) to extend diametrally thereof and which is fixedly secured to the first-mentioned elongate member (8).

7. A connector as claimed in claim 2 or 3, wherein said grip (42) is provided with a colour coded fitting (16).

## Patentansprüche

1. Verbindungsteil, geeignet zum Gebrauch beim Verbinden zweier Komponenten (2A, 2B), wobei die Komponenten jeweils Oberflächen haben, die aufeinanderstoßen, wenn die Komponenten miteinander verbunden sind, umfassend
i) eine Welle (1) mit einem Gewinde im Endbereich (1a) und einem vom Endbereich entfernten radialen Flansch (35), wobei die Welle zudem einen Durchgang (60) enthält, der sich mindestens über einen Teil ihrer axialen Länge erstreckt;
ii) eine zur Welle koaxiale, um sie herum angeordnete Buchse (11), wobei die Buchse (11) eine Endfläche in der Nähe des Wellenendbereichs mit dem Gewinde und einen radialen, von der Endfläche entfernten Flansch (53) hat;
iii) eine zwischen dem radialen Flansch (35) der Welle (1) und dem radialen Flansch (53) der Buchse (11) angebrachte Vorspanneinrichtung (4), um die Buchse damit axial entlang der Welle in eine Richtung weg vom radialen Flansch der Welle zu drücken;
iv) ein längliches, zum Bewegen entlang des Durchgangs (60) in der Welle (1) angeordnetes Glied (8), das mit der Buchse (11) verbunden ist, um sich abhängig von der Axialbewegung der Buchse mitzubewegen, wobei das längliche Glied einen Abschnitt (80) hat, der am vom Gewindebereich entfernten Ende (la) der Welle über dieses Ende hinaus vorsteht;
v) eine mit dem Abschnitt (80) des länglichen Glieds (8) verbundene Anzeigeeinrichtung (110), die auf die Bewegung des länglichen Gliedes anspricht; und
vi) eine weitere Vorspanneinrichtung (9), die die Anzeigeeinrichtung (110) von der Welle (1) wegdrücken will, wobei die Anzeigeeinrichtung (110) anzeigt, ob die Kraft, die die beiden aneinanderstoßenden Komponenten (2A, 2B) zusammendrückt, einen vorbestimmten Wert übersteigt.

2. Verbindungsbauteil nach Anspruch 1, das zudem einen drehbaren, mit der Welle (1) verbundenen Griff (42) am vom Gewindebereich entfernten Ende (la) der Welle umfaßt, so daß das Drehen des Griffs die Drehung der Welle veranlaßt, und der Endbereich (80) des länglichen Gliedes axial aus dem Griff (42) hervorsteht.

3. Verbindungsbauteil nach Anspruch 2, wobei der Griff (42) eine Drehmomentbegrenzungsvorrichtung (47, 48, 49) umschließt, geeignet zum Begrenzen des auf die Welle (1) aufgebrachten Drehmoments, nachdem die beiden Komponenten relativ zueinander korrekt angeordnet wurden, wie dies die Anzeigeeinrichtung (110) anzeigt.

4. Verbindungsbauteil nach Anspruch 1, 2 oder 3, wobei die Anzeigeeinrichtung (110) so angeordnet ist, daß sie auf eine Kraft anspricht, die zu der Kraft direkt proportional ist, mit der die Komponenten (2A, 2B) aneinander anstoßend zusammengedrückt werden.

5. Verbindungsbauteil nach irgendeinem vorhergehenden Anspruch, wobei die Anzeigeeinrichtung (110) auf eine Bewegung des verlängerten Bauelements (8) anspricht, um anzuzeigen, ob die Welle (1) und die Buchse (11) relativ zueinander in vorbestimmten Stellungen sind.

6. Verbindungsbauteil nach irgendeinem vorhergehenden Anspruch, wobei die Welle (1) mit einem Schlitz (5) gebildet ist, in dem eine an der Buchse (11) befestigte Stange (12) gleitet, die sich diametral über die Buchse erstreckt und starr am erstgenannten länglichen Glied (8) befestigt ist.

7. Verbinder nach Anspruch 2 oder 3, wobei der Griff (42) mit einem farbig kodierten Anschlußstück (16) versehen ist.

## Revendications

1. Elément de connexion destiné à être utilisé pour connecter l'un à l'autre deux composants (2A, 2B), ces composants ayant des surfaces respectives qui, lorsque les composants sont connectés l'un à l'autre, portent l'une contre l'autre, l'élément de connexion comprenant :
i) un axe (1) comportant une région d'extrémité filetée (1a) et, à distance de ladite région d'extrémité, un collet (35), l'axe comportant en outre un passage (60) s'étendant axialement sur au moins une partie de sa longueur axiale;
ii) un manchon (11) coaxial à l'axe (1) et placé autour de cet axe, le manchon (11) comportant une surface d'extrémité voisine de la région d'extrémité filetée de l'axe et un collet radial (53) éloigné de ladite surface d'extrémité;
iii) un moyen de sollicitation (4) disposé entre le collet radial (35) de l'axe (1) et le collet radial (53) du manchon (11) pour pousser le manchon axialement le long de l'axe dans une direction d'éloignement par rapport au collet radial de l'axe;
iv) un organe allongé (8) disposé en vue d'un déplacement le long du passage (60) de l'axe (1) et couplé au manchon (11) de manière à être soumis à ce déplacement en fonction du déplacement axial du manchon, cet organe allongé comportant une région (80) s'étendant hors de l'axe à l'extrémité de celui-ci qui est éloignée de la région d'extrémité filetée (1a) de l'axe;
v) un moyen d'indication (110) couplé à ladite région (80) de l'organe allongé (8) et sensible au déplacement de celui-ci; et
vi) un autre moyen de sollicitation (9) tendant à pousser ledit moyen d'indication (110) en l'éloignant dudit axe (1) grâce à quoi ledit moyen d'indication (110) indique le moment où la force poussant les deux composants précités (2A, 2B) l'un contre l'autre dépasse une valeur prédéterminée.

2. Elément de connexion selon la revendication 1, qui comprend en outre un élément de préhension tournant (42) éloigné de ladite région d'extrémité filetée (1a) de l'axe et accouplé à l'axe (1) de sorte que la rotation dudit élément de préhension provoque la rotation dudit axe, ladite région d'extrémité (80) de l'organe allongé s'étendant dans le sens axial de l'élément de préhension (42).

3. Elément de connexion selon la revendication 2, dans lequel ledit élément de préhension (42) comprend un dispositif (47, 48, 49) de limitation de couple pour limiter le couple appliqué à l'axe (1) après que les deux composants ont été positionnés de façon correcte l'un par rapport à l'autre, comme indiqué par le moyen d'indication (110).

4. Elément de connexion selon la revendication 1, 2 ou 3, dans lequel ledit moyen d'indication ( 110) est conçu pour réagir à une force qui est directement proportionnelle à la force poussant les deux composants (2A, 2B) l'un contre l'autre.

5. Elément de connexion selon l'une quelconque des revendications précédente, dans lequel ledit moyen d'indication (110) réagit au déplacement de l'organe allongé (8) en indiquant si l'axe (1) et le manchon (11) se trouvent ou ne se trouvent pas dans des position prédéterminées l'un par rapport à l'autre.

6. Elément de connexion selon l'une quelconque des revendications précédentes, dans lequel ledit arbre (1) comporte une fente (5) dans laquelle coulisse une barre (12) qui est fixée au manchon (11) de manière à s'étendre dans le sens du diamètre de celui-ci et qui est fixée solidement au premier organe allongé (8) mentionné en premier;

7. Elément de connexion selon la revendication 2 ou 3, dans lequel l'élément de préhension (42) est pourvu d'une pièce (16) codée en couleurs.
